## Europäisches Patentamt
## European Patent Office
## Office européen des brevets

(19)

(11) Veröffentlichungsnummer: **0 012 838**
**B1**

(12)

# EUROPÄISCHE PATENTSCHRIFT

(45) Veröffentlichungstag der Patentschrift:
15.09.82

(21) Anmeldenummer: 79104582.6

(22) Anmeldetag: 19.11.79

(51) Int. Cl.³: **H 01 J 37/08,** H 01 J 1/16,
H 01 L 21/265

(54) Ionenquelle, insbesondere für Ionenimplantationsanlagen.

(30) Priorität: 22.12.78 DE 2855864

(43) Veröffentlichungstag der Anmeldung:
09.07.80 Patentblatt 80/14

(45) Bekanntmachung des Hinweises auf die Patenterteilung:
15.09.82 Patentblatt 82/37

(84) Benannte Vertragsstaaten:
DE FR GB

(56) Entgegenhaltungen:
DE-A-1 964 694
DE-A-2 363 088
DE-B-2 527 609
FR-A-1 374 335
GB-A-1 359 707
GB-A-1 377 544
US-A-3 075 078
US-A-4 056 723
SOLID STATE TECHNOLOGY, November 1977, R.
DUCHYNSKI »Ion Implantation for Semiconductor Devices«, Seiten 53—58

(73) Patentinhaber: International Business Machines
Corporation, Armonk, N.Y. 10504 (US)

(72) Erfinder: Hinkel, Holger, Dr., Zeisigweg 13,
D-7030 Böblingen (DE)
Erfinder: Kraus, Georg, Im Heinental 70,
D-7277 Wildberg-4 (DE)

(74) Vertreter: Gaugel, Heinz, Dipl.-Ing., Schönaicher
Strasse 220, D-7030 Böblingen (DE)

Ionenquelle, insbesondere für Ionenimplantationsanlagen

Die Erfindung betrifft eine Ionenquelle, insbesondere für Ionenimplantationsanlagen, mit direkt gleichstrombeheizter, stabförmiger Kathode in einer die Anode bildenden Entladungskammer, aus der der erzeugte Ionenstrahl über elektrische und/oder magnetische Extraktionsfelder herausgeführt wird.

Die Ionenimplantation findet bei der industriellen Produktion von Halbleiterbauelementen und integrierten Schaltungen Anwendung und führt zu einer wesentlichen Verbesserung dieser Produkte. Unter Ionenimplantation als Verfahren der Halbleitertechnik versteht man den Beschuß eines Einkristalls durch schwere, hochenergetische Ionen mit dem Zweck einer gezielten Veränderung der elektrischen Materialeigenschaften in einer Oberflächenschicht des Kristalls. Die Ionenimplantation ist also ein modernes Verfahren zur Dotierung eines Halbleitermaterials. Der Vorteil der Ionenimplantation liegt darin, daß die dotierten Bereiche sowohl geometrisch als auch im bezug auf die Konzentrationsverteilung der implantierten Dotierstoffe viel genauer als mit bisherigen Verfahren hergestellt werden können. Die besseren Qualitäten implantierter Bereiche im Vergleich zu diffundierten Bereichen liegen in einer exakteren Begrenzung der Bereiche, die stärkste Konzentration der Dotierstoffe muß nicht an der Oberfläche des Halbleiterkristalls liegen, das Konzentrationsprofil kann entweder durch Mehrfachimplantation oder durch Anwendung verschiedener Implantationsenergien differenziert gewählt werden und die dotierten Bereiche sind weitgehend frei von Verunreinigungen und Nebeneffekte sind im wesentlichen nicht feststellbar. Ein Vorteil der Ionenimplantation liegt auch darin, daß keine hohen Temperaturen aufzuwenden sind, wodurch vorausgegangene Verfahrensschritte weniger beeinflußt werden.

Das Prinzip einer Implantationsanlage besteht darin, daß von einer geeigneten Ionenquelle gelieferte Ionen eines durch einen Massenseparator ausgewählen Elementes fokussiert und beschleunigt werden. Das gebildete Ionenstrahlbündel wird auf die zu dotierende Halbleiteroberfläche gerichtet. Mit Hilfe eines Ablenksystems kann der Ionenstrahl über die gesamte Oberfläche geführt werden. Beim Aufprall der Ionen auf die Halbleiteroberfläche vermag der nicht rückgestreute Anteil wegen der hohen kinetischen Energie in den Halbleiterkörper einzudringen.

Ein wesentlicher Bestandteil dieser Ionenimplantationsanlagen ist die Ionenquelle. An eine Ionenquelle werden insbesondere folgende Anforderungen gestellt. Die Ionenquelle soll Ionen aller gewünschten Sorten mit gutem Wirkungsgrad erzeugen. Außerdem soll die Ionenquelle möglichst hohe Ionenströme liefern. Schließlich erwartet man von einer Ionenquelle, daß sie nur wenig Wartung erforderlich macht.

Man unterscheidet im wesentlichen zwei Typen von Ionenquellen, die Kaltkathoden- und die Glühkathodenquelle. Die Kaltkathodenquelle hat den Nachteil, daß die erzielbaren Ionenströme relativ niedrig sind. Die Glühkathodenquelle bietet den Vorteil, daß mit ihr hohe Ionenströme erreichbar sind. Für hohe Dotierungen, wie sie beispielsweise für die Emitter- und Subkollektorzone von bipolaren Transistoren erforderlich sind, sind hohe Ionenströme (Milliamperebereich) nötig, wenn ein Durchsatz von mehr als beispielsweise 10 Halbleiterscheiben pro Stunde angestrebt wird.

Gegenwärtig werden im wesentlichen zwei Typen von Heißkathodenquellen verwendet. Der wesentlichen Unterschied besteht in der Ausführung der Kathode. Die eine Ionenquelle arbeitet mit einer stabförmigen Kathode, die den Vorteil hat, daß die Quelle sehr stabil ist und auch ohne äußeres Magnetfeld betrieben werden kann. Der Nachteil dieser Quelle liegt in der Begrenzung des maximalen Ionenstroms auf ca. 2 mA (bei Arsen) und in einer begrenzten Lebensdauer der Kathode. Die Kathode wird durch die auftretende Sputtererosion zerstört.

Die andere Heißkathodenquelle arbeitet mit einer U-förmigen Kathode, die weniger schnell erodiert und damit eine höhere Lebensdauer gewährleistet. Diese Quelle liefert auch höhere Ionenströme. Der Nachteil liegt in der geringeren Stabilität des Plasmas und darin, daß diese Quelle nur mit einem äußeren Magnetfeld betrieben werden kann.

Es ist die der Erfindung zugrunde liegende Aufgabe, eine Ionenquelle mit direkt gleichstrombeheizter, stabförmiger Kathode in einer die Anode bildenden Entladungskammer anzugeben, wobei die Lebensdauer gegenüber der entsprechenden bekannten Quelle beträchtlich erhöht und gleichzeitig der maximal extrahierbare Ionenstrom vergrößert ist.

Die Lösung dieser Aufgabe ist in den Patentansprüchen niedergelegt.

Die Erfindung wird im folgenden anhand der Zeichnung näher erläutert. Es zeigt

Fig. 1 in beträchlich vereinfachter schematischer Darstellung den Aufbau einer bekannten Ionenimplantationsanlage,

Fig. 2 in vergrößerter schematischer Darstellung die Schnittansicht einer Heißkathodenquelle des der Erfindung zugrunde liegenden Typs,

Fig. 3A den Verlauf der elektrischen und magnetischen Felder im Bereich der Kathode innerhalb der Entladungskammer,

Fig. 3B in schematischer Ansicht die Bahn der von der Kathode emittierten Elektronen,

Fig. 4A und 4B eine bekannte stabförmige Kathode im unbenutzten und im bereits erodierten Zustand,

Fig. 4C und 4D die erfindungsgemäße stabförmige Kathode im unbenutzten und im erodierten Zustand,

Fig. 5A den Verlauf des Kathodenstromes Ic einer erfindungsgemäßen Kathode a) und der bekannten Kathode b) in Abhängigkeit von der Benutzungsdauer t und

Fig. 5B den Verlauf des Ionenstromes Ii einer erfindungsgemäßen Kathode a) und der bekannten Kathode b) in Abhängigkeit von der Benutzungsdauer t.

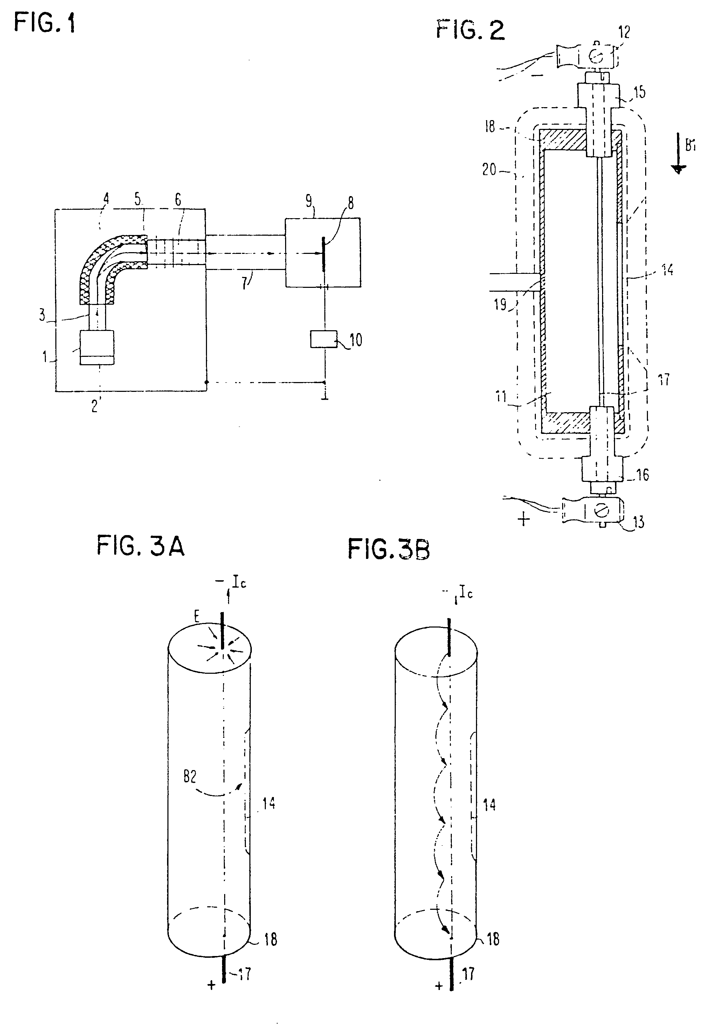

Zunächst sei anhand der Fig. 1 in stark vereinfachter Form der Aufbau und die Wirkungsweise einer Ionenimplantationsanlage beschrieben, wie sie dem heutigen Stand der Technik entspricht. Wesentlichster Teil ist die eigentliche Ionenquelle 1. In dieser Ionenquelle wird der Dotierungsstoff 2 in einer Entladungskammer in atomare und molekulare Bestandteile zerlegt und ionisiert. Am Ausgang der Ionenquelle erhält man damit ein Gemisch verschiedener Ionensorten. Alle diese Ionensorten werden aus der Quelle extrahiert und fokussiert. Dazu dient eine am Ausgang der Ionenquelle 1 angeordnete Extraktions- und Fokussierungseinrichtung 3. Ein von der Extraktionseinrichtung geliefertes elektrisches Feld von einigen kV/cm saugt die Ionen aus der Quelle ab. Die Fokussierungseinrichtung fokussiert den Ionenstrahl auf den Eintrittsspalt eines Massenseparators 4. Dieser umfaßt als wesentlichsten Bestandteil einen Ablenkmagneten, der aus der Vielzahl der von der Ionenquelle gelieferten unterschiedlichen Ionen, die mit der gewünschten Masse und Ladung aussortiert. Den Massenseparator 4 verläßt somit über eine Ausgangsblende 5 ein hochreiner Strahl von Ionen mit exakt definierter Energie. Dieser Ionenstrahl durchläuft dann eine Beschleunigungsstrecke 6. Dabei wird mit Hilfe elektrostatischer Linsen der Ionenstrahl auf einen geeigneten Durchmesser fokussiert. Die auf hohe Energie beschleunigten Ionen gelangen über eine Ablenkeinheit 7 auf die Bestrahlungsebene 8 in der Bestrahlungskammer 9. Die Ablenkeinheit führt den Brennfleck des Ionenstrahls in gewünschter Weise über die Bestrahlungsebene, in der sich die zu bestrahlende Probe befindet. Ein Stromintegrator 10 bestimmt die Anzahl der implantierten Ionen aufgrund ihrer Ladungen. Das ganze Strahlführungssystem samt der Bestrahlungskammer ist hoch evakuiert.

Die Fig. 2 zeigt die wesentlichen Bestandteile der Ionenquelle 1, wie sie im Rahmen der Erfindung Verwendung findet. Es handelt sich um eine Heißkathodenquelle mit direkt gleichstrombeheizter, stabförmiger Kathode. Die Ionenquelle umfaßt eine zylindrische Entladungskammer 11, die in Achsrichtung einen Schlitz 14 als Strahlausgang aufweist. Über isolierende Durchführungen 15, 16 in den Stirnseiten der Endladungskammer ist eine stabförmige Elektrode, beispielsweise aus Wolfram, durch die Entladungskammer 11 geführt. Diese stabförmige Elektrode bildet die direkt beheizte Glühkathode 17. Die Kathode 17 ist vorzugsweise nicht in der Mittelachse der Entladungskammer 11 angeordnet, sondern ist etwas zum Schlitz 14 hin verschoben. Gegenüber dem Schlitz 14 befindet sich im Gehäuse 18 der Entladungskammer 11 eine Zufuhröffnung 19, über die der in der Entladungskammer zu ionisierende Dotierungsstoff, beispielsweise in Form eines geeigneten Gases zugeführt wird. Das Gehäuse 18 der Entladungskammer 11 besteht aus leitendem Material und ist allseitig von einer Wärmestrahlungsabschirmung 20 umgeben. Die Kathode 17 ist an elektrische Anschlüsse 12 und 13 gelegt.

Im Betrieb wird das Gehäuse 18 der Entladungskammer 11 gegenüber der Kathode 17 positiv vorgespannt. Das Gehäuse 18 bildet damit die Anode der Entladungskammer. Zusätzlich wird der Kathode über die Anschlüsse 12, 13 ein Heizstrom in Form eines Gleichstromes zugeführt. Die auf diese Weise als Glühkathode wirkende Kathode 17 emittiert Elektronen. Von den aus der Kathode emittierten Elektronen geht durch Stöße mit den in die Entladungskammer eingeführten Gasmolekülen die Ionisation aus, die im elektrischen Feld zwischen Kathode und dem als Anode wirkenden Gehäuse der Entladungskammer zu einer Glimmentladung führt. Ein Teil der Ionen wird durch den Schlitz 14 in der Entladungskammer durch ein zusätzliches elektrisches Feld extrahiert. In manchen Fällen ist ein zusätzliches äußeres Magnetfeld B1 vorgesehen. Der weitere Verlauf des gebildeten Ionenstrahls ist bereits eingangs im Prinzip angegeben worden.

Anhand der Fig. 3A und 3B, die in rein schematischer Darstellung die Entladungskammer mit dem Gehäuse 18, dem Extraktionsschlitz 14 und der Kathode 17 zeigen, wird der Hauptnachteil der bekannten Ionenquellen dieser Art erläutert. Der Hauptnachteil liegt darin, daß die Kathode 17 nur eine begrenzte Lebensdauer aufweist. Die Kathode wird durch Sputtererosion zerstört. Dabei handelt es sich um eine einseitige Erosion, die letztlich durch das Magnetfeld des Kathodenstromes Ic hervorgerufen wird. Dieses Magnetfeld treibt die von der Heißkathode emittierten Elektronen in das eine Ende der Entladungskammer 11. Dort ist dann die Wahrscheinlichkeit für eine Ionisation von Gasatomen und Erosion der Kathode durch Ionen sehr groß.

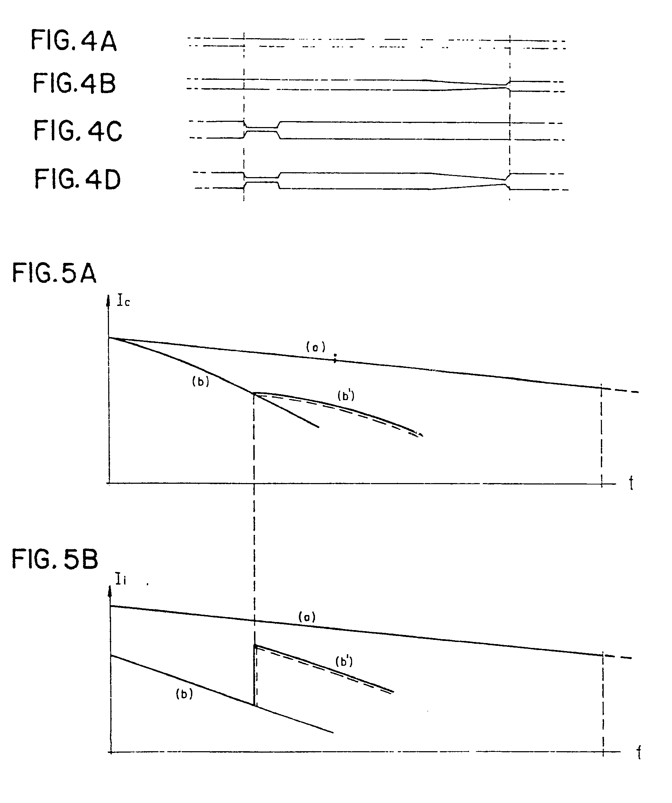

Man kann beobachten, daß die Kathode der betrachteten Ionenquelle bevorzugt am elektrisch positiven Ende erodiert. Diese Tatsache läßt sich anhand der schematischen Darstellung nach Fig. 3A erklären. Die von der Glühkathode 17 emittierten Elektronen bewegen sich in einem radialen elektrischen Feld E, das durch die Bogenspannung zwischen der Kathode und dem als Anode wirkenden Gehäuse 18 der Entladungskammer 11 verursacht wird. Außerdem bewegen sich die Elektronen in einem zirkularen magnetischen Feld B2, das durch den Kathodenstrom Ic (Größenordnung beispielsweise 150 A) verursacht wird. Aus der Wirkung dieser Felder resultiert eine Bewegung aller emittierten Elektronen, die sich als Pseudozykloide entlang der Kathode in Richtung vom negativen zum positiven Ende darstellen läßt (Fig. 3B). Am positiven Ende wird also die Wahrscheinlichkeit für die Ionisierung neutraler Gasatome besonders groß sein. Treffen die positiven Ionen auf die Kathode 17 auf, so wird sie erodiert, vorzugsweise also an ihrem positiven Ende. Die Wirkung dieser Erosion ergibt sich für die bekannte, stabförmige, einen gleichbleibenden Querschnitt aufweisende Kathode aus der schematischen Darstellung in den Fig. 4A und 4B. Fig. 4A zeigt diese bekannte Kathode im jungfräulichen, unbenutzten Zustand. Fig. 4B zeigt diese Kathode im benutzten erodierten Zustand. Die Erosion führt am positiven Ende der Kathode zu einer zu nehmenden Verjüngung und bestimmt damit die Lebensdauer der Kathode. Der Verlauf des Kathodenstromes Ic und des erzielten Ionenstromes Ii für die bekannte, anfänglich einen gleichförmigen Querschnitt aufweisende Kathode ist aus den Fig. 5A und 5B durch die Kurven b angedeutet. Daraus ist zu ersehen, daß mit zunehmender Benutzungsdauer t, also mit zunehmender Erosion der Kathode am positiven Ende der Kathodenstrom Ic infolge des zunehmenden ohmschen Widerstandes der Kathode rasch abfällt. Entsprechend ergibt sich ein rascher Abfall des erzielbaren Ionenstromes Ii.

Man kann nun beobachten, daß durch Umpolen der einseitig erodierten, konventionellen Kathode der Abfall des Kathodenstromes Ic zunächst verlangsamt wird, was sich aus der gestrichelten Kurve b' in Fig. 5A ergibt. Von größerer Bedeutung ist jedoch, daß bei diesem Umpolen, bei dem das erodierte Ende zum negativen Pol gemacht wird, der Ionenstrom Ii sprunghaft auf einen Wert ansteigt, der um etwa 50 bis 70% größer ist als bei einer neuen, konventionellen Kathode. Dies ist durch die gestrichelte Kurve b' in Fig. 5B angedeutet. Die Beobachtung, daß der Ionenstrom Ii beim Umpolen der einseitig erodierten konventionellen Kathode auf einen höheren Wert steigt als bei einer jungfräulichen Kathode, läßt sich folgendermaßen deuten. Ist der Querschnitt der Kathode an einer Stelle stark reduziert, so erwärmt sie sich dort bei Stromfluß besonders stark. An dieser Stelle werden dann besonders viele Elektronen emittiert. Liegt diese Stelle am negativen Ende der Kathode, so bewegen sich die dort emittierten Elektronen durch die gesamte Entladungskammer bevor sie auf die als Anode wirkende Kammerwandung treffen. Damit ist aber die Ionisationswahrscheinlichkeit gegenüber einer Kathode mit gleichförmigem Querschnitt stark erhöht, da die meisten Elektronen eine größere Weglänge zurücklegen müssen.

Ausgehend von dieser Beobachtung wird nun die Kathode erfindungsgemäß so gestaltet, daß ihr Querschnitt von Anfang an am negativen Ende wesentlich kleiner gewählt ist als am positiven Ende. Eine entsprechend ausgebildete erfindungsgemäße Kathode ist in Fig. 4C im jungfräulichen und in Fig. 4D im erodierten Zustand dargestellt.

Der Fig. 5A ist der Verlauf des Kathodenstromes Ic in Abhängigkeit von der Benutzungsdauer t für die erfindungsgemäße Kathode in Form der Kurve a zu entnehmen. Der Kathodenstrom Ic fällt nur geringfügig ab und bleibt über die gesamte Lebensdauer relativ konstant. Die Fig. 5B zeigt durch die Kurve a, daß der Ionenstrom Ii in Abhängigkeit von der Benutzungsdauer t bei der erfindungsgemäßen Kathode ebenfalls relativ konstant bleibt. Die Ursache für diese Eigenschaften der erfindungsgemäßen Kathode liegen in einer bewußten Verfügung der Kathode am negativen Ende. Diese Verjüngung bestimmt im wesentlichen den Widerstand der Kathode während der Gesamtlebensdauer. Es ist also nur ein relativ geringer Anstieg dieses Widerstandes infolge der am positiven Ende stattfindenden Erosion festzustellen. Außerdem wird durch die Verjüngung am negativen Ende bewirkt, daß von dort infolge der herrschenden höheren Temperatur die meisten Elektronen emittiert werden, die dann den relativ weiten Weg zum positiven Ende zurücklegen. Das hat zur Folge, daß die Ionisationswahrscheinlichkeit gegenüber einer konventionellen Kathode beträchtlich erhöht ist, so daß auch der absolute Wert des erzielbaren Ionenstromes beträchtlich erhöht ist.

Zusammenfassend kann man feststellen, daß bei einem Vergleich der Widerstände der konventionellen und der erfindungsgemäßen Kathode im jungfräulichen und im erodierten Zustand bei der konventionellen Kathode der Widerstand im Betrieb stark ansteigt (etwa 100%) bei der erfindungsgemäßen Kathode dagegen nur wenig (etwa 20%). Das hat zu Folge, daß der Kathodenstrom im ersten Fall mit der Zeit deutlich abnimmt, im zweiten Fall dagegen nur wenig.

Bei der Verwendung der konventionellen Kathode sinkt der Ionenstrom Ii im Laufe der Zeit stark ab, und zwar wegen des abnehmenden Kathodenstromes Ic (abnehmende Heizleistung und weil sich der Bereich hohen Widerstandes schnell zum ungünstigen positiven Kathodenende verlagert. Beide Nachteile sind bei der erfindungsgemäßen Kathode eliminiert: Der Widerstand der Kathode und damit der Kathodenstrom Ic ist über die gesamte Betriebszeit nahezu konstant und das Gebiet hohen Widerstandes liegt stets am negativen Ende der Kathode. Dies führt dazu, daß der Ionenstrom bei Benutzung der neuen Kathode wesentlich langsamer abnimmt.

Außerdem ist zusätzlich die Lebensdauer der neuen Kathode — wegen des größeren Querschnitts am positiven Ende — erhöht, beim Ausführungsbeispiel der Fig. 4C und 4D um einen Faktor 2 (verglichen mit einer beidseitig erodierten konventionellen Kathode).

## Patentanspruch

Ionenquelle, insbesondere für Ionenimplantationsanlagen, mit direkt gleichstrombeheizter, stabförmiger Glühkathode in einer die Anode bildenden Entladungskammer, aus der der erzeugte Ionenstrahl über elektrische und/oder magnetische Extraktionsfelder herausgeführt wird, dadurch gekennzeichnet, daß die stabförmige Kathode im Bereich ihres elektrisch negativen Endes einen gegenüber ihrem restlichen Teil verringerten Querschnitt aufweist.

## Claim

Ion source, in particular for ion implantation systems, with a directly DC heated, rod-shaped cathode in a discharge chamber forming the anode and from which the ion beam generated is extracted via electric and/or magnetic fields, characterized in that the rod-shaped cathode has a smaller cross-section in the region of its electrically negative end than in its remaining part.

## Revendication

Source d'ions, en particulier pour des systèmes d'implantation ionique, comportant une cathode incandescente en forme de bâton directement chaffée par un courant continu dans une chambre de décharge formant l'anode, de laquelle on extrait le faisceau d'ions généré à travers des champs d'extraction électrique et/ou magnétique, caractérisée en ce que la cathode en forme de bâton présente dans la région de son extrémité électriquement négative une coupe transversale plus réduite que dans sa partie restante.

# FIG. 1

# FIG. 2

# FIG. 3A

# FIG.3B

FIG. 4A

FIG. 4B

FIG. 4C

FIG. 4D

FIG. 5A

FIG. 5B